# EUROPÄISCHE PATENTSCHRIFT

(11) **EP 1 842 595 B1**
(45) Veröffentlichungstag und Bekanntmachung des Hinweises auf die Patenterteilung: **16.09.2009**
(21) Anmeldenummer: 07105092.6
(22) Anmeldetag: 28.03.2007
(51) Int. Cl.: B02C 25/00, B02C 23/08, B02C 21/00, B07C 5/08, C01B 33/02, C30B 15/00, C30B 29/06

(54) **Verfahren und Vorrichtung zum Zerkleinern und Sortieren von Polysilicium**
Method and device for comminuting and sorting polysilicon
Procédé et dispositif pour broyer et trier de polysilicium

(30) Priorität: 06.04.2006 DE 102006016323
(43) Veröffentlichungstag der Anmeldung: 10.10.2007
(73) Patentinhaber: Wacker Chemie AG, 81737 München (DE)
(72) Erfinder: Schäfer, Marcus, Dr., 83278 Traunstein (DE); Pech, Reiner, Dr., 84524 Neuötting (DE); Schantz, Matthäus, 84367 Reut (DE)
(74) Vertreter: Potten, Holger

(56) Entgegenhaltungen:
- EP-A1- 0 876 851
- EP-A1- 1 334 907
- DD-A1- 241 557
- DE-A1- 3 811 091
- DE-A1-102005 019 873
- JP-A- 57 067 019
- US-A- 4 881 689

## Beschreibung

Die Erfindung betrifft ein Verfahren und eine Vorrichtung zum Zerkleinern und Sortieren von hochreinem polykristallinem Silicium.

Hochreines polykristallines Silicium, im Folgenden als Polysilicium bezeichnet, dient u. a. als Ausgangsmaterial für die Herstellung von elektronischen Bauteilen und Solarzellen. Es wird durch thermische Zersetzung eines siliciumhaltigen Gases oder eines siliciumhaltigen Gasgemisches gewonnen. Dieser Prozess wird als Abscheidung aus der Dampfphase (CVD, chemical vapor deposition) bezeichnet. In großem Maßstab wird dieser Prozess in so genannten Siemens-Reaktoren realisiert. Das Polysilicium fällt dabei in Form von Stäben an. Die Polysiliciumstäbe werden in der Regel mittels händischer Verfahren zerkleinert. Der so erhaltene Polysilicium-Grobbruch hat eine nicht reproduzierbare Größenverteilung, es fallen kaum kleinere Bruchgrößen in höheren Mengen an.
Es sind eine Reihe maschineller Verfahren bekannt, in denen händisch vorgebrochener Polysilicium-Grobbruch unter Einsatz üblicher Brecher weiter zerkleinert wird. Mechanische Brechverfahren sind beispielsweise in EP 1 338 682 A2 beschrieben. Es sind auch mechanische Brechverfahren in Kombination mit einer aufwendigen thermischen Vorbehandlung der Polysilciumstäbe bekannt, die ein einfacheres Brechen des Polysiliciums ermöglichen sollen (z. B. EP 1 338 682 A2). Anschließend wird der Polysilicium-Bruch mit einem Siebverfahren, z. B. einem mechanischen Siebverfahren wie aus EP 1043249 B1 bekannt, oder einer optischen Sortierung, wie z. B. aus US 6,265,683 B1 bekannt, klassiert.

Aus dem Abstract von JP 57067019 A ist eine Vorrichtung sowie ein Verfahren zum Zerkleinern und Sortieren von polykristallinem Silicium umfassend eine Aufgabevorrichtung für einen Siliciumgrobbruch in eine Brecheranlage, die Brecheranlage und eine Sortieranlage zum Klassieren des Siliciumbruchs bekannt.

Aus DE 38 11 091 A1 ist ein Verfahren zum Zerkleinern von massivem stückigem Silicium bekannt, bei dem die Gefahr von Kontaminationen dadurch gering gehalten wird, dass in einem ersten Schritt in den Siliciumstücken durch Wärmeeinwirkung von außen ein Temperaturgradient erzeugt wird, dessen Richtung in einem zweiten Schritt rasch zumindest teilweise umgekehrt wird. Diese Behandlung bewirkt eine Dekompaktierung, die es ermöglicht, bei einem nachfolgenden mechanischen Zerkleinerungsschritt Werkzeuge zu verwenden, deren mit dem Silicium in Kontakt kommende Oberflächen aus Silicium oder aus Hartstoffen z. B. auf Nitrid- oder Carbidbasis bestehen.

Aufgabe der vorliegenden Erfindung ist es, eine Vorrichtung zum Zerkleinern und Sortieren von Polysilicium zur Verfügung zu stellen, welche die Herstellung eines reproduzierbaren Polysilicium-Bruchs mit definierten Eigenschaften in erhöhter Ausbeute in nur einer zusammenhängenden Anlage ermöglicht.

Diese Aufgabe wird gelöst durch eine Vorrichtung umfassend eine Aufgabeeinrichtung für einen Polysilicium-Grobbruch in eine Brecheranlage, die Brecheranlage und eine Sortieranlage zum Klassieren des Polysilicium-Bruchs, dadurch gekennzeichnet, dass die Brechanlage mit einer Steuerung versehen ist, die eine variable Einstellung mindestens eines Brechparameters in der Brecheranlage und mindestens eines Sortierparameters in der Sortieranlage ermöglicht.

Vorzugsweise umfasst die Vorrichtung ferner eine Fördervorrichtung von der Brecheranlage zu der Sortieranlage.

Eine bevorzugte Ausführungsform der Vorrichtung ist dadurch gekennzeichnet, dass die Sortieranlage mit einer Messeinrichtung für definierte Parameter des klassierten Polysilicium-Bruchs versehen ist und diese Messeinrichtung mit einer übergeordneten Steuer- und Regeleinrichtung verbunden ist, welche die gemessenen Parameter statistisch auswertet und mit vorgegebenen Parametern vergleicht und bei einer Abweichung zwischen gemessenen Parameter und vorgegebenen Parameter die Einstellung des Brechparameters der Brecheranlage und des Sortierparameters der Sortieranlage derart verändern kann, dass sich der dann gemessene Parameter dem vorgegebenen Parameter angleicht.

Vorzugsweise wird ein Parameter aus der Gruppe Länge, Fläche, Form, Morphologie, Farbe und Gewicht der Polysilicium-Bruchstücke gemessen. Die Länge eines Bruchstücks ist dabei vorzugsweise definiert als die längste gerade Linie zwischen zwei Punkten auf der Oberfläche des Bruchstücks. Die Fläche eines Bruchstücks ist dabei vorzugsweise definiert als die größte in eine Ebene projizierte Schattenfläche des Bruchstücks.

Besonders bevorzugt wird die Länge oder die Fläche der Polysilicium-Bruchstücke gemessen und in Form von Längen oder Flächenverteilungen ausgewertet (z. B. 5 %, 50 % oder 95 % Quantil). Alternativ werden die Gewichtsausbeuten der einzelnen Sieb-Fraktionen von den Waagen an den Siebausgängen bestimmt. Zur Stabilisierung der gewünschten Ausbeuten, können entweder die mit einer Waage erfassten Gewichte der einzelnen Fraktionen, oder die in der optoelektronischen Trennanlage gemessenen Längenverteilungen der einzelnen Bruchfraktionen herangezogen werden. Ist z. B. der Mengenanfall an großen Bruchstücken zu groß oder der an der ersten optischen Trennstufe ermittelte Längenmittelwert (Ist-Wert) der Bruchverteilung größer als der Soll-Wert, so wird der Spaltabstand entsprechend einer im Rezept festgelegten Logik reduziert, so dass sich die Bruchverteilung dadurch zum Kleineren hin verschiebt.

Im Stand der Technik erfolgte die Sortierung der Polysilicium-Bruchstücke immer entkoppelt vom Zerkleinern. Damit ist bisher keine Regelung der Zerkleinerung des Polysiliciums in Abhängigkeit von dem Bruchergebnis möglich. Durch die erfindungsgemäße Kombination und vorzugsweise Rückkopplung der Messwerte einer optoelektronischen Sortierung und/oder der Waagen an den Sortierausgängen mit einer Datenerfassung und Datenauswertung sowie der Integration aller Anlagenteile einschließlich der Brecher in einer übergeordneten Steuerung, ist erstmals eine gezielte zeitnahe Regelung der Zerkleinerung zur Erzielung eines reproduzierbar definierten Polysilicium-Bruchs in guten Ausbeuten möglich.

Bei der Brecheranlage handelt es sich vorzugsweise um eine mehrstufige Brecheranlage bestehend aus 1 bis 10 Brechern (entspricht 1 bis 10 Brechstufen), vorzugsweise aus 1 bis 3 Brechern. Es können alle bekannten Brecher eingesetzt werden. Bevorzugt werden Walzenbrecher oder Backenbrecher eingesetzt. Besonders bevorzugt werden Walzenbrecher mit synchron laufenden Walzen eingesetzt. Als Walzenbrecher kommen besonders bevorzugt Stachelwalzenbrecher zum Einsatz.

Variable einstellbare Brechparameter der Brecher sind vorzugsweise der Spaltabstand (Zahnspitze zu gegenüberliegenden Walzenboden) oder die Drehgeschwindigkeiten der Walzen. Diese Parameter können über die übergeordnete Steuer- und Regelvorrichtung variiert werden.

Überraschenderweise lassen sich für die einzelnen Brechstufen feste Parameter (z. B. Durchmesser der Walzen, Zahnabstand, Zahnhöhe) so einstellen, dass es möglich ist, mehrere Zielfraktionen von Polysilicium-Brüchen mit unterschiedlichen Korngrößenbereichen mittels einer ein- oder mehrstufigen Brecheranlage, nur durch eine Variation des Spaltabstands und der Drehgeschwindigkeit der Walzen, herzustellen. Unter einer Zielfraktion ist dabei die Bruchgrößenfraktion zu verstehen, die nach der Zerkleinerung und Klassierung die höchste Ausbeute am gesamten Bruchgrößenspektrum aufweist.

Vorzugsweise werden Durchmesser, Zahnabstand und Zahnhöhe eines Walzenbrechers wie folgt gewählt:
Der Zahnabstand auf einer Walze ist über die Diagonale zwischen den Mittelpunkten von zwei nebeneinander liegenden Zähnen definiert. Der Zahnabstand wird üblicherweise in einem Bereich von 5 - 200 mm gewählt, in einer zweistufigen Brecheranlage bevorzugt 100 - 200 mm in der ersten Brechstufe und 5 - 100 mm in der zweiten Brechstufe, in einer dreistufigen Brecheranlage bevorzugt 100 - 200 mm in der ersten Brechstufe, 50 - 100 mm in der zweiten Brechstufe und 5 - 50 mm in einer dritten Brechstufe. Die Zahnhöhe wird üblicherweise von 5 - 100 mm gewählt. Die Zahnform kann zylindrisch, kegelförmig, pyramidenförmig bzw. eine Kombination aus diesen Formen sein. Der Walzendurchmesser liegt üblicherweise im Bereich von 200 - 2000 mm, in einer zweistufigen Brecheranlage bevorzugt 800 - 2000 mm in der ersten Stufe und 200 - 800 mm in der zweiten Stufe, in einer dreistufigen Brecheranlage bevorzugt 800 - 2000 mm in der ersten Stufe, 500 - 800 mm in der zweiten Stufe und 200-500 mm in der dritten Stufe.

Je nach gewünschter Bruchgrößenverteilung des Endproduktes kommen eine oder mehrere Brechstufen zum Einsatz. Die Bruchgröße definiert die minimale und maximale Länge einer Fraktion von Bruchstücken. Für die gezielte Herstellung eines Polysilicium-Bruchs mit einer Bruchgröße von 5 bis 80 mm kommen bevorzugt zwei bis vier Brechstufen, besonders bevorzugt zwei Brechstufen zum Einsatz. Für die gezielte Herstellung eines Polysilicium-Bruchs mit einer Bruchgröße von 60 bis 250 mm kommen bevorzugt 1 oder 2 Brechstufen zum Einsatz. Besonders bevorzugt kommt nur eine Brechstufe zum Einsatz.

In einer Ausführungsform wird der Siliciumbruch innerhalb der Brecheranlage über eine Fördervorrichtung automatisch von einer Brechstufe zur nächsten Brechstufe gefördert. Als Fördervorrichtung wird bevorzugt ein Förderband oder eine Förderrinne eingesetzt. Besonders bevorzugt werden Förderrinnen eingesetzt. Es ist dabei möglich, eine Brechstufe über einen Bypass zu umgehen. Die Ansteuerung des Bypass ("Bypass AUF", "Bypass ZU") ist in die übergeordnete Steuerung der Gesamtanlage integriert.

In einer anderen Ausführungsform sind die Brechstufen direkt untereinander angeordnet. In diesem Fall wird das Umgehen einer Brechstufe durch volles Auffahren der Walzen realisiert, wobei der Walzenabstand mindestens doppelt so groß ist, wie die maximale Länge des Aufgabematerials.

Von der Brecheranlage wird der Siliciumbruch vorzugsweise über eine Fördervorrichtung, besonders bevorzugt eine Förderrinne, automatisch zur Sortieranlage gefördert.

Bei der Sortieranlage handelt es sich vorzugsweise um eine mechanische Siebanlage und/oder einer optoelektronischen Trennanlage, besonders bevorzugt um eine optoelektronische Trennanlage. Beispielsweise handelt es sich um eine Vorrichtung wie sie in EP 0 876 851 B1 (entspricht US 6,040,544 A) beschrieben ist. Auf den Inhalt dieser Schriften wird zur Offenbarung der optoelektronischen Trennanlage verwiesen und ausdrücklich Bezug genommen.

Besonders bevorzugt besteht die Sortieranlage aus einer mehrstufigen mechanischen Siebanlage und einer mehrstufigen optoelektronischen Trennanlage. Als mechanische Siebanlage können alle in der Fachliteratur bekannten mechanischen Siebmaschinen eingesetzt werden. Bevorzugt werden Schwingsiebmaschinen, die über einen Unwuchtmotor angetrieben werden, eingesetzt. Als Siebbelag sind Maschen- und Lochsiebe bevorzugt. Die mechanische Siebanlage dient zur Abtrennung von Feinanteilen im Produktstrom. Der Feinanteil enthält Korngrößen bis zu 25 mm, bevorzugt bis 10 mm. Durch die mehrstufige mechanische Siebanlage wird der Feinanteil noch in weitere Fraktionen aufgetrennt. Besonders bevorzugt wird eine zweistufige mechanische Siebanlage eingesetzt.

Die Siebstufen können hintereinander oder auch in einer anderen Struktur, wie z. B. einer Baumstruktur, angeordnet sein. Bevorzugt sind die Siebe in drei Stufen in einer Baumstruktur angeordnet. So werden beispielsweise bei einer Aufteilung des Poly-Bruchs in vier Kornfraktionen (z. B. Fraktion 1, 2, 3, 4) in einer ersten Stufe Fraktion 1 und 2 von Fraktion 3 und 4 getrennt. In einer zweiten Stufe werden dann Fraktion 1 von Fraktion 2 und einer parallel angeordneten dritten Stufe Fraktion 3 von Fraktion 4 getrennt.

Der von Feinanteilen befreite Polysilicium-Bruch wird vorzugsweise mittels optoelektronischer Trennanlage sortiert. Die Sortierung des Polysilicium-Bruchs kann nach allen Kriterien, die Stand der Technik in der Bildbearbeitung sind, erfolgen. Sie erfolgt vorzugsweise nach ein bis drei der Kriterien ausgewählt aus der Gruppe Länge, Fläche, Form, Morphologie, Farbe und Gewicht der Polysilicium-Bruchstücke, besonders bevorzugt Länge und Fläche.

Andere Kombinationen bekannter elektronischer Sensortechniken für die Parametererkennung der Polysilicium-Bruchstücke sind jedoch ebenso geeignet (z. B. Metalldetektor, Ultraschall, Infrarot). Die optische Bilderkennung der optoelektronischen Trennanlage hat den Vorteil, dass "wirkliche" Längen oder Flächen gemessen werden. Dies erlaubt eine gegenüber herkömmlichen mechanischen Siebverfahren genauere Trennung der Bruchstücke nach den jeweils erwünschten Parametern.

Die beispielsweise in der optoelektronischen Trennanlage mittels des On-Line Monitorings bestimmte Ist-Verteilung des Aufgabematerials ohne Feinanteil (z. B. Längenverteilung, Flächenverteilung) wird an die übergeordnete Steuer- und Regeleinrichtung übermittelt und dort mit vorgegebenen Soll-Verteilungen verglichen. Bei einer Abweichung zwischen gemessener (Ist) und vorgegebener (Soll) Verteilung werden die variablen Brechparameter der Brechanlage (z. B. die Spalteinstellung oder die Drehzahl der Walzen oder die Anzahl der Brechstufen) durch die Steuer- und Regeleinrichtung derart verändert, dass sich die gemessene Verteilung der vorgegebenen Verteilung angleicht.

In einer bevorzugten Ausführungsform umfasst die Anlage nach der Sortieranlage Waagen zur Bestimmung der Gewichtsausbeuten der klassierten Fraktionen. Vorzugsweise umfasst die Vorrichtung nach der Sortieranlage eine vollautomatische Kistenabfüll- und Kistentransportvorrichtung.

In einer weiteren bevorzugten Ausführungsform umfasst die erfindungsgemäße Vorrichtung vor der Aufgabeeinrichtung eine maschinelle Vorzerkleinerung. Prinzipiell ist jede bekannte maschinelle Vorzerkleinerung geeignet, bevorzugt wird eine Vorrichtung eingesetzt, umfassend eine Unterlage sowie Zerkleinerungsmeißel und Gegenmeißel wobei Zerkleinerungsmeißeln und Gegenmeißel eine Längsachse besitzen, die parallel zur Unterlage ausgerichtet ist und Zerkleinerungsmeißeln und Gegenmeißel derart beweglich sind, dass ein auf der Unterlage liegender zu zerkleinernder Siliciumstab zwischen den Meißeln derart justiert werden kann, dass alle Meißel im Bereich des Siliciumstabs Kontakt zum Siliciumstab besitzen und die Zerkleinerungsmeißel vor und hinter dem Siliciumstab in Richtung ihrer Längsachse bis auf einen Sicherheitsabstand zum Gegenmeißel gefahren werden können, und die Meisel mittels einer schlagförmigen Bewegung in Richtung ihrer Längsachse auf den Siliciumstab einwirken und diesen zertrümmern. Ein geeigneter Vorzerkleinerer ist beispielsweise in DE 102005019873 beschrieben.

Mit einer maschinellen Vorzerkleinerung ermöglicht die erfindungsgemäße Vorrichtung erstmals eine vollautomatische Zerkleinerung von beliebig großen Polysiliciumstücken, von kleinen Bruchstücken bis zu ganzen Polysiliciumstäben, wie sie im Siemens Prozess anfallen. Dieses Ausgangsmaterial wird vollautomatisiert, und regelbar zu einer jeweils gewünschten Zielfraktion reproduzierbar zerkleinert, erstmals ohne jedwede mechanische Umbauten in den Einzelanlagen. Zudem ermöglicht das Verfahren ein sicheres Arbeiten und eine bessere Arbeitsergonomie für die Mitarbeiter, da während des gesamten Zerkleinerungs- und Klassiervorganges keinerlei manuelle Arbeitsschritte erforderlich sind.

Die Steuer- und Regelvorrichtung besteht vorzugsweise aus einem Leitsystem in Form einer speicherprogrammierbaren Steuerung (SPS) über die die Steuerungen aller Teilanlagen (z. B. Vorbrecher, Fördereinrichtungen, Brecheranlage, mechanische und optoelektronische Sortieranlage, automatisiertes Kistenhandling mit Rezeptverwaltung und Verwaltung der Regellogik) verwaltet und geregelt werden. Die teilanlagenübergreifende Visualisierung und Bedienung erfolgt von einem übergeordneten Leitsystem. Die Stör- und Betriebsmeldungen aller Teilanlagen werden in einer Stör- bzw. Betriebsmeldungs-Datenbank zusammenkopiert, ausgewertet und visualisiert.

Erst durch die geschickte Kombination der Einzelanlagen zur erfindungsgemäßen Vorrichtung und die logischen Verknüpfung mittels übergeordneter Steuerung wurde eine Anlage möglich, mit der jede Art von Polysiliciumbruch ("klein" und "groß") hergestellt werden kann, ohne dass dabei mechanische Umbauten für verschiedene Brech- oder Sortierprozesse notwendig sind.

Die Eingabe der gewünschten Zielfraktion in die übergeordnete Steuer- und Regelvorrichtung bewirkt eine entsprechende Einstellung der Parameter der Brecher zur Erzielung der gewünschten Bruchgröße des Polysilicium-Bruchs.

Zwischen den einzelnen Brecherstufen sowie innerhalb und nach den Sortieranlagen können Magnetabscheider (z. B. Plattenmagneten, Trommelmagneten oder Bandmagneten) angeordnet werden, um metallische Fremdkörper aus dem Polysilicium-Bruch zu entfernen und die Metallkontamination des Polysilicium-Bruchs zu reduzieren.

Eine weitere Aufgabe der vorliegenden Erfindung ist es, ein Verfahren zum Zerkleinern und Sortieren von Polysilicium zur Verfügung zu stellen, welches zu einem Polysilicium-Bruch mit reproduzierbaren definierten Eigenschaften in erhöhter Ausbeute führt.

Diese Aufgabe wird gelöst durch ein Verfahren, bei dem ein Polysilicium-Grobbruch in einer erfindungsgemäßen Vorrichtung zerkleinert wird. Dazu wird der Polysilicium-Grobbruch vorzugsweise in eine Brecheranlage, bei der eine variable Einstellung mindestens eines Brechparameters möglich ist, gefördert und dort zu einem Polysilicium-Bruch zerkleinert, welcher anschließend in eine Sortieranlage gefördert und dort klassiert wird, wobei in der Sortieranlage jeweils ein oder mehrere Ist-Werte für einen definierten Parameter des Polysilicium-Bruchs gemessen werden und der oder die gemessene Ist-Werte an eine übergeordnete Steuer- und Regeleinrichtung weitergeleitet werden, und in der Steuer- und Regeleinrichtung mit einem vorgegebenen Soll-Wert verglichen werden und bei einer Abweichung zwischen Ist-Wert und Soll-Wert die Steuer- und Regeleinrichtung die Einstellung des Brechparameters der Brecheranlage derart verändert, dass sich der Ist-Wert des Polysilicium-Bruchs dem vorgegebenen Soll-Wert angleicht.

Das Verfahren nutzt vorzugsweise die in der Beschreibung der Vorrichtung genannten Parameter.

Ist beispielsweise der an der ersten optischen Trennstufe ermittelte Längenmittelwert (Ist-Wert) der Bruchverteilung größer als der Soll-Wert, so wird der Spaltabstand in dem Brecher entsprechend nachgeregelt bzw. reduziert, so dass sich die Bruchverteilung dadurch zum Kleineren hin verschiebt.

Die Messung der Produktparameter sowie der Klassierung des Polysilicium-Bruchs erfolgt vorzugsweise wie im Folgenden beschrieben:
Das Überkorn der ersten mechanischen Siebstufe wird einer mehrstufigen optoelektronischen Trennanlage zugeführt. In jeder optoelektronischen Sortierstufe wird der Produktstrom über eine integrierte Schwingförderrinne vereinzelt und passiert über eine Rutsche im freien Fall eine (oder mehrere) CCD-Farbzeilenkamera(s), die eine Klassifizierung nach einem oder mehreren der Parameter Länge, Fläche, Volumen, Form, Morphologie und Farbe in beliebiger Kombination vornimmt. Für die Parametererkennung der Bruchstücke können alternativ alle dem Stand der Technik bekannten elektronischen Sensortechniken eingesetzt werden. Die Messwerte werden an die übergeordnete Steuer- und Regeleinrichtung übermittelt und z. B. mittels Mikroprozessor ausgewertet. Dabei wird durch Vergleich mit dem im Rezept hinterlegten Sortierkriterium entschieden, ob ein Bruchstück aus dem Produktstrom ausgeschleust oder durchgelassen wird. Die Ausschleusung erfolgt vorzugsweise durch Druckluftimpulse. Dabei werden beispielsweise über eine unter der Bilderkennung angeordnete Ventilleiste Trennkanäle (Druckluftleisten) angesteuert und mit dosierten Druckluftimpulsen, die von der Korngröße abhängig sind, beaufschlagt. Der Durchlassstrom und der Abweisstrom werden danach getrennt abgeführt und der nächsten optoelektronischen Sortierstufe zugeführt. Alternativ kann die Ausschleusung auch hydraulisch oder mechanisch erfolgen.

Die sensorische Erkennung, bevorzugt optische Bilderkennung, hat den Vorteil, dass ",wirkliche" Längen, Flächen oder Formen gemessen werden. Dies erlaubt zum einen gegenüber herkömmlichen mechanischen Siebverfahren eine definierte und genauere Trennung, z. B. bzgl. Länge. Der Überlapp zwischen zwei zu trennenden Fraktionen ist geringer. Zum anderen können die Trenngrenzen beliebig über die vorgegebenen Parameter (das Rezept) der übergeordneten Steuerung eingestellt werden, ohne dass Änderungen an der Maschine selber vorzunehmen sind (wie z. B. Wechsel der Siebbeläge). Dementsprechend ist die optoelektronische Siebanlage gleichermaßen für Trennungen im kleinen wie im großen Bruchgrößenbereich einsetzbar. Darüber hinaus kann über "on-line-Messung" die Gesamtanlage geregelt werden, indem zum Beispiel der Spaltabstand entsprechend dem Brechergebnis unmittelbar korrigiert wird. Des Weiteren bietet die optoelektronische Sortierung den Vorteil, dass durch die Kombination aus Fläche und Länge eine genauere Trennung der Bruchstücke nach den jeweiligen Anforderungen (z. B. hohe Kubizität der Bruchstücke) möglich ist.

Die klassierten Fraktionen des Silicium Bruchs werden gesammelt und bevorzugt in Kisten abgefüllt. Die Abfüllung ist vorzugsweise automatisiert, wie beispielsweise in EP 1 334 907 B beschrieben. Vorzugsweise sind Kistentransport und die Abfüllung des klassierten Materials vollständig automatisiert.

Vorzugsweise umfasst das Verfahren ein maschinelles Vorzerkleinern. Das Vorzerkleinern erfolgt vorzugsweise dergestalt, dass das polykristalline Silicium im Vorzerkleinerer auf einer höhenverstellbaren Unterlage platziert wird und dort zwischen Zerkleinerungsmeißeln und Gegenmeißeln derart justiert wird, dass alle Meißel im Bereich des Siliciums Kontakt zum Silicium besitzen und Zerkleinerungsmeißel und Gegenmeißel vor oder hinter dem Silicium einander bis auf einen Sicherheitsabstand angenähert werden und anschließend bei allen am Silicium anliegenden Zerkleinerungsmeißeln ein wiederkehrender Schlagimpuls gestartet wird, der eine Zerkleinerung des Siliciums bewirkt.

Bei dem eingesetzten polykristallinen Silicium handelt es sich vorzugsweise um polykristalline Siliciumstäbe, wie sie beispielsweise bei der Si-Abscheidung im Siemens Prozess erhalten werden. Darüber hinaus können beliebig geformte Reste aus anderen Silicumbearbeitungsverfahren (z. B. Tiegelziehprozessen, Schneidverfahren, etc.) eingesetzt werden.

Das erfindungsgemäße Verfahren ermöglicht eine gezielte und reproduzierbare Herstellung von Polysiliciumbruch in beliebiger Größenverteilung mit einer maximalen Bruchgröße von 250 mm.

Es ist zudem mittels des Verfahrens erstmals möglich, gezielt nicht mehr fließfähigen kubischen Polysilicium-Bruch einer Größe von 45 bis 250 mm reproduzierbar in einer hohen Ausbeute herzustellen.

Ein solcher Bruch ist für das Erreichen eines hohen Füllgrads eines Tiegels in Tiegelanwendungen notwendig. Darüber hinaus ergibt sich aufgrund der geringeren spezifischen Oberfläche eines solchen Bruchs eine geringere spezifische Kontaminationsfläche und damit eine bessere Qualität, da z. B. bei Tiegelanwendungen der Metalleintrag pro Kilogramm Tiegeleinwaage geringer wird. Weitere Vorteile größerer Bruchgrößen liegen in einer verbesserten Wirtschaftlichkeit nachfolgender Reinigungsprozesse, weil der Säureverbrauch umso geringer ist je niedriger die spezifische Oberfläche des zu reinigenden Polysilicum-Bruchs ist.

An das erfindungsgemäße Verfahren schließt sich vorzugsweise eine Reinigung des Polysilicium-Bruchs an.

Diese Reinigung kann wie beispielsweise in EP 1338682 A2 S. 8, Absatz 0054 oder 0055 US 6309467 beschrieben, erfolgen. Ein derart hergestellter Siliciumbruch hat eine Reinheit auf Halbleiterniveau und erfüllt damit mindestens die folgenden Forderungen an die Oberflächen-Reinheit: Monitorelement Eisen im Mittel <100pptw, bevorzugt kleiner <50pptw.
Fig. 1 zeigt die in den Beispielen verwendete erfindungsgemäße Vorrichtung mit einem Vorbrecher.
Fig. 2 zeigt das Ergebnis der Mahlung aus Bsp. 2

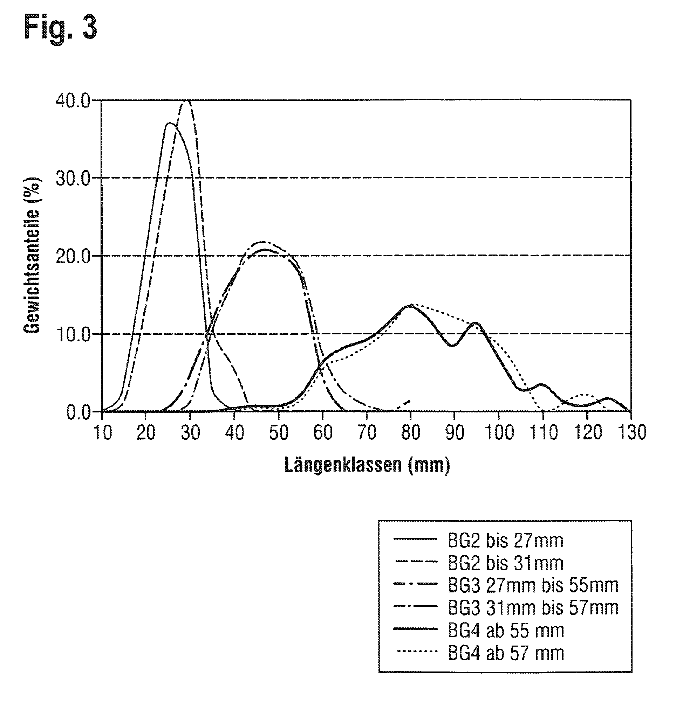

Fig. 3 zeigt den Einfluss der in der bei der optoelektronischen Trennanlage eingestellten Sortiergrenze "maximale Länge eines Bruchstückes" auf die Bruchgrößenverteilung der klassierten Fraktionen.

Die folgenden Beispiele dienen der weiteren Erläuterung der Erfindung. Folgende Bruchgrößen wurden in den Beispielen hergestellt:
Fraktion 0: Bruchgrößen mit einer Verteilung von ca 0 bis 3 mm Fraktion 1: Bruchgrößen mit einer Verteilung von ca. 1 mm bis 10 mm
Fraktion 2: Bruchgrößen mit einer Verteilung von ca. 10 mm bis 40 mm
Fraktion 3: Bruchgrößen mit einer Verteilung von ca. 25 mm bis 65 mm
Fraktion 4: Bruchgrößen mit einer Verteilung von ca. 50 mm bis 110 mm
Fraktion 5: Bruchgrößen mit einer Verteilung von ca. > 90 mm bis 250 mm

In die übergeordnete Mess- und Steuervorrichtung werden die Parameter für die herzustellende Zielfraktion eingegeben. Da durch die jeweilige Weiterverwendung des herzustellenden Bruchs eine jeweils gewünschte Korngrößenverteilung in der Zielfraktion und den Nebenfraktionen jeweils vorgegeben wird, sind die Zielfraktionen in der Regel als Rezepte in der übergeordneten Mess- und Steuervorrichtung hinterlegt und werden dementsprechend ausgewählt. Im vorliegenden Beispiel wurde die Vorrichtung für die Herstellung von vier verschiedenen Zielfraktionen (Fraktion 2, 3, 4 und 5) eingesetzt. Bei der Herstellung einer Zielfraktion entstehen auch Nebenfraktionen (Unterfraktionen und teilweise Überfraktionen). In den Rezepten sind jeweils alle Parameter für den Vorzerkleinerer, den Brecher und die optoelektronische Trennanlage hinterlegt. Im Beispiel (für die gezielte Herstellung von Fraktion 5) wurden folgende Parameter im Rezept hinterlegt:

Anzahl/Auswahl der schlagenden Meißelpaare und Vorschub des Schlittens in der Art, dass die gewählte Einstellung zu Schlägen auf dem Polysiliciumstab bzw. zu zerkleinernden Material im Abstand von etwa 15 cm führt.

Die erste Brechstufe wurde mit einer Umfangsgeschwindigkeit von 1 m/sec und einem Spaltabstand (Zahnspitze zu gegenüberliegenden Walzenboden) von 90 mm betrieben. Weitere Brechstufen wurden über einen Bypass umgangen.

Der Feinanteil (Fraktion 0 und 1) des so gebrochenen Materials wurde am mechanischen Sieb mit einer Maschenweite von etwa 10 mm abgetrennt und anschließend der abgetrennte Anteil mit einer weiteren mechanischen Siebanlage bzw. einem weiteren Sieb mit ca. 4 mm Maschenweite in die Fraktionen 0 und 1 getrennt.

Der Grobanteil (Fraktion 2, 3, 4 und 5) wurde über eine Förderrinne (deren Fördercharakteristiken, wie z. B. Frequenz, ebenfalls im Rezept hinterlegt sind) der optischen Trennanlage zugeführt und über drei optische Stufen wie folgt getrennt: In der ersten Stufe wurde Fraktion 3 & 2 von Fraktion 4 & 5 getrennt. Als Trenngrenze wurde im Rezept eine maximale Länge von 55 mm hinterlegt. Die Fraktion 3 & 2 wurde in einer zweiten Stufe bzw. einer im Rezept hinterlegten Trenngrenze von 30 mm in die Fraktionen 3 und 2 getrennt. Die Fraktion 4 & 5 in einer dritten Stufe und einer Trenngrenze von 100 mm in die Fraktionen 4 und 5.

Zwischen den verschiedenen Anlagenteilen, wie z. B. Förderrinnen, können nach Stand der Technik bekannte Magneten zur Abscheidung von metallischen Kontaminationen eingebaut sein.

Als Regelparameter werden die Messgrößen Länge und/oder Fläche verwendet, und/oder die mit Waagen gemessenen Gewichtsausbeuten an den Ausgängen der Sortieranlage. Stellgrößen sind der Vorschub des Vorzerkleinerers und die Spaltabstände der Brecher. Die Stellgrößen sind im Rezept vorbelegt. Die Logik zwischen Regelparameter und Stellgrößen ist ebenfalls im Rezept hinterlegt. Dies ist in Bsp. 4 dargestellt.

### Beispiel 1:

Eine Polysiliciumstab (L = 0,25 - 4 m, D = 20 - 250 mm) wird auf den Bruchtisch des Vorzerkleinerers gelegt. Auf dem Bruchtisch erfolgt eine visuelle Qualitätskontrolle des Stabes auf Fremdkörper, Beläge und Morphologie der Oberfläche. Der Stab wird auf einen Brechschlitten gelegt, der den Stab automatisch in die Brechkammer fördert.

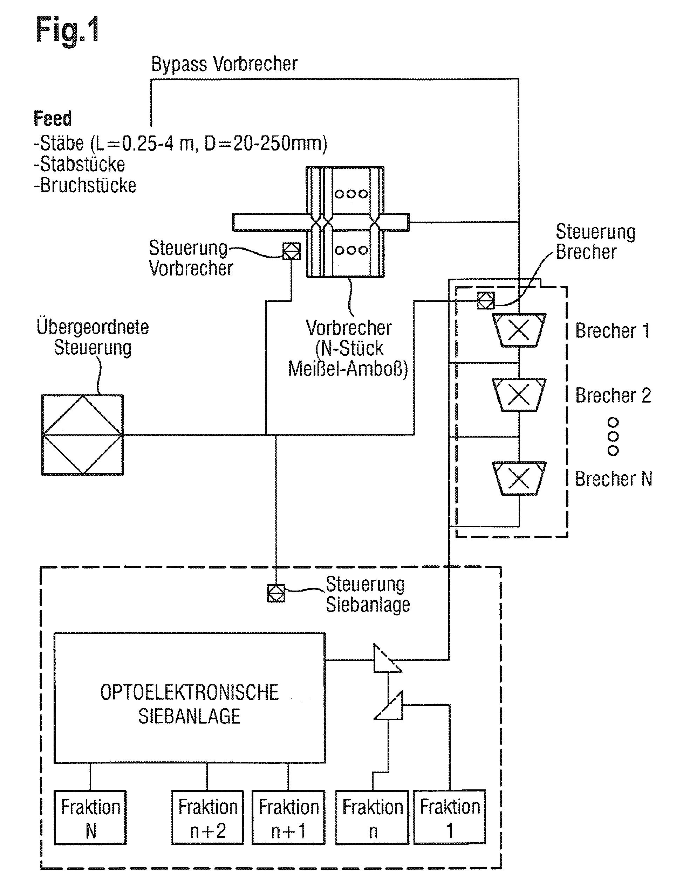

In einer Vorrichtung analog Fig. 1 aus DE 102005019873 wird ein zu zerkleinernder Si-Stab auf dem Auflageprisma der Unterlage abgelegt. Die Längsseiten zwei zueinander parallel angeordneter Trogschalen bilden das Auflageprisma. Die Trogschalen sind drehbar auf dem Brechschlitten installiert.

Ein parallel zum Brechschlitten installiertes Führungslineal begünstigt die Fixierung des Si-Stabes während der Bestückung. Anschließend wird der Brechschlitten mit dem Si-Stab in den Brechraum, den Bereich zwischen den Meißeln, eingefahren. Der Brechablauf wird über eine Wegerfassung des Schlittens gesteuert und kann variabel gewählt werden. Nachdem der Brechschlitten seine Position erreicht hat, werden erst die 3 Gegenmeißel an den Stab zur Fixierung herangefahren. Die Zerkleinerungsmeißel werden zeitversetzt an den Stab herangefahren und der Brechzyklus gestartet. Der Brechvorgang wird erst unterbrochen, wenn das erste Stabstück gebrochen ist und die Zerkleinerungsmeißel eine definierte Endstellung erreicht haben. Dann werden Zerkleinerungsmeißel und Gegenmeißel zeitgleich in die Ausgangsstellung zurück gefahren und der Brechschlitten in die nächste Brechposition getaktet. Der Brechvorgang beginnt von neuem. Dieser Vorgang wird solange wiederholt, bis der ganze Stab gebrochen ist. Dabei kann die Länge der Si-Stäbe unterschiedlich sein. Nach dem Brechvorgang wird der Brechschlitten in eine definierte Endstellung gefahren, die drehbar gelagerten Trogschalen um ca. 150° gegeneinander gedreht und der Si-Bruch auf eine unter dem Brechschlitten installierte Förderrinne zum Weitertransport entleert.

Die vorzerkleinerten Bruchstücke (der Polysilicium-Grobbruch) haben eine Länge kleiner als 25 cm. Sie werden automatisch in eine Förderrinne entleert, die das Material zur mehrstufigen Brecheranlage fördert.

### Beispiel 2:

Statt des Polysiliciumstabs werden einzelne Silicium Bruchstücke einer Länge größer 25 cm auf den Bruchtisch gelegt und wie in Bsp. 1 beschrieben zerkleinert.

### Beispiel 3

Ein Polysilicium-Grobbruch (aus Beispiel 1, 2 oder der händischen Zerkleinerung gemäß Stand der Technik) wird über eine Aufgabevorrichtung, vorzugsweise einen Trichter, einem Walzenbrecher zugeführt.

Die erste Brechstufe wird für die gezielte Herstellung von Fraktion 5 mit einer Umfangsgeschwindigkeit von 1 m/sec und einem Spaltabstand (Zahnspitze zu gegenüberliegenden Walzenboden) von 90 mm betrieben. Weitere Brechstufen wurden über einen Bypass umgangen. Das gebrochene Material wird über eine Förderrinne (deren Fördercharakteristiken, wie z. B. Frequenz, ebenfalls im Rezept hinterlegt sind) der Sortieranlage zugeführt

Der Feinanteil (Fraktion 0 und 1) des so gebrochenen Materials wird am mechanischen Sieb mit einer Maschenweite von etwa 10 mm abgetrennt und anschließend der abgetrennte Anteil mit einer weiteren mechanischen Siebanlage, bzw. einem weiteren Sieb mit ca. 4 mm Maschenweite in die Fraktionen 0 und 1 getrennt.

Der Grobanteil (Fraktion 2, 3, 4 und 5) wird der optischen Trennanlage zugeführt und über drei optische Stufen wie folgt getrennt: In der ersten Stufe wurde Fraktion 3 & 2 von Fraktion 4 & 5 getrennt. Als Trenngrenze wurde im Rezept für Polysilicium-Bruchstücke eine maximale Länge von 55 mm hinterlegt, d.h. Bruchstücke, deren Länge kleiner als 55 mm ist, werden ausgeblasen. Die ausgeblasene Fraktion 3 & 2 wurde über eine Förderrinne und einer anschließenden zweiten Trennstufe bzw. einer im Rezept hinterlegten Trenngrenze von 30 mm in die Fraktionen 3 und 2 getrennt. Die Fraktion 4 & 5 wurde in einer dritten Stufe bei einer Trenngrenze von 100 mm in die Fraktionen 4 und 5 getrennt.

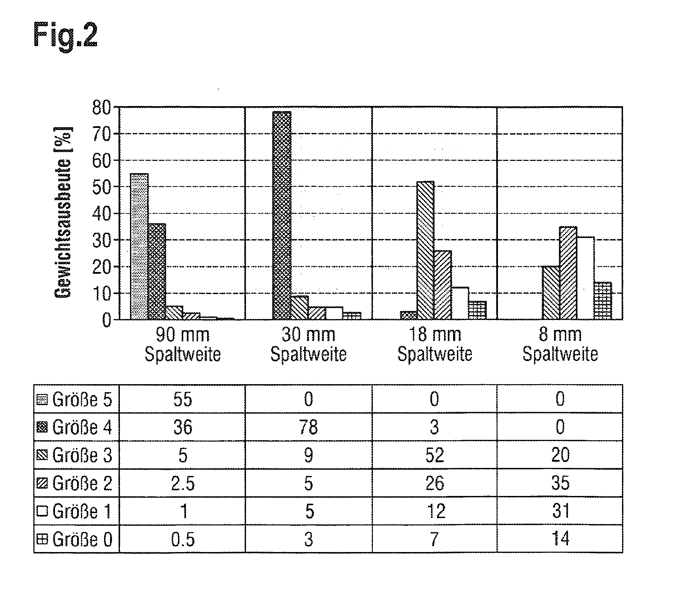

Fig. 2 zeigt das Ergebnis der Zerkleinerung und Klassierung. Es ist gut ersichtlich, dass durch eine Kombination von 2 hintereinander angeordneten Brechern und einer entsprechenden Wahl der Spaltabstände jede beliebige Korngrößenverteilung (durch einfache Parametereingabe) hergestellt werden kann.

So lassen sich große Bruchstücke mit einer Länge von mehr als 90 mm (Größe 5) und einer Kubitität von > 3 g/mm z.B. mit einer Gewichtsausbeute von > 50 % mit einer Walze (Durchmesser 1 m) und einem Walzenabstand von etwa 90 mm herstellen. Der Nebenanfall an Feinbruch (Größe 2,1 und 0, mit einer Länge von weniger als 40 mm) ist kleiner als 5 Gew.%.

Feinbruch mit einer Länge von weniger als 40 mm (Größe 2, 1 und 0) kann andererseits z. B. mit einer Gewichtsausbeute von > 80 % mit einer Kombination von 30 mm und anschließend 8 mm Walzenabstand (Walzendurchmesser 650 mm) hergestellt werden. Es findet sich kein Nebenanfall der großen Bruchstücke (Größe 4 und 5) .

Die Gewichts-Ausbeuten im Beispiel wurden zu Vergleichszwecken über eine separate Waage bzw. Gewichtsmessung der einzelnen Fraktionen nach Brechen und Sieben an den Ausgängen der Sortieranlage mit Waagen gemessen.

Die mit der "on-line-Messung" bestimmten Parameter werden an die übergeordnete Steuer- und Regeleinheit zurückgemeldet, und dort mit den ausgewählten vorgegebenen Parametern verglichen. Soweit erforderlich, wird nun z. B. der Spaltabstand des Walzenbrechers unmittelbar korrigiert bzw. nachgeregelt um die gemessenen Parameter in Übereinstimmung mit den vorgegebenen Parametern zu bringen.

### Bsp. 4:

Es wurden die Softwareparameter bzgl. Trenngrenzen der einzelnen Fraktionen variiert. Im Rezept zur Steuerung der optoelektronischen Trennanlage wurden die Werte bzgl. maximal oder minimal erlaubter Länge der Bruchstücke in den einzelnen Fraktionen um wenige Millimeter geändert. Im Beispiel wurde die Trenngrenze für das Ausblasen zwischen den Fraktionen 2 und 3 von 27 mm auf 31 mm und zwischen den Fraktionen 3 und 4 von 55 mm auf 57 mm verändert. Diese Programm-Parameter-Änderung von nur wenigen Millimetern ist bereits in den ProduktEigenschaften (z. B. Längenverteilung) ersichtlich, d. h. die Trenngrenzen zwischen den einzelnen Fraktionen können mit hoher Genauigkeit durch einfache Rezeptwahl flexibel an die jeweilige Kundenspezifikation angepasst werden, oder im Rahmen der online Regelung zur Erzielung gewünschter Soll-Werte herangezogen werden.

## Patentansprüche

1. Vorrichtung zum Zerkleinern und Sortieren von polykristallinem Silicium, umfassend eine Aufgabeeinrichtung für einen Polysilicium-Grobbruch in eine Brecheranlage, die Brecheranlage, und eine Sortieranlage zum Klassieren des Polysilicium-Bruchs, **dadurch gekennzeichnet, dass** die Vorrichtung mit einer Steuerung versehen ist, die eine variable Einstellung mindestens eines Brechparameters in der Brecheranlage und mindestens eines Sortierparameters in der Sortieranlage ermöglicht.

2. Vorrichtung gemäß Anspruch 1, **dadurch gekennzeichnet, dass** sie eine Fördervorrichtung von der Brecheranlage zu der Sortieranlage umfasst.

3. Vorrichtung gemäß Anspruch 1 oder 2, **dadurch gekennzeichnet, dass** die Sortieranlage mit einer Messeinrichtung für definierte Parameter des klassierten Polysilicium-Bruchs versehen ist und diese Messeinrichtung mit einer übergeordneten Steuer- und Regeleinrichtung verbunden ist, welche die gemessenen Parameter mit einem vorgegebenen Parameter vergleicht und bei einer Abweichung zwischen gemessenen Parameter und vorgegebenen Parameter die Einstellung des Brechparameters der Brecheranlage und des Sortierparameters der Sortieranlage derart verändern kann, dass sich der dann gemessene Parameter dem vorgegebenen Parameter angleicht.

4. Vorrichtung gemäß Anspruch 1, 2 oder 3, **dadurch gekennzeichnet, dass** die Brecheranlage eine mehrstufige Brecheranlage bestehend aus 1 bis 10 Brechern, vorzugsweise aus 1 bis 3 Brechern ist.

5. Vorrichtung gemäß Anspruch 4, **dadurch gekennzeichnet, dass** die Brecher Walzenbrecher oder Backenbrecher, bevorzugt Walzenbrecher, besonders bevorzugt Stachelwalzenbrecher sind.

6. Vorrichtung gemäß einem der Ansprüche 1 bis 5, **dadurch gekennzeichnet, dass** die Sortieranlage aus einer mehrstufigen mechanische Siebanlage und einer mehrstufigen optoelektronischen Trennanlage besteht.

7. Vorrichtung gemäß einem der Ansprüche 1 bis 6, **dadurch gekennzeichnet, dass** eine zweistufige mechanische Siebanlage in Kombination mit einer dreistufigen optoelektronische Trennanlage, aufgebaut in einer Baumstruktur, eingesetzt wird, bei der die Sortierung des Polysilicium-Bruchs, mittels On-line Monitoring nach einem oder mehreren der Kriterien ausgewählt aus der Gruppe Länge, Fläche, Form, Morphologie, Farbe und Gewicht der Polysilicium-Bruchstücke, erfolgt.

8. Vorrichtung gemäß einem der Ansprüche 1 bis 7, **dadurch gekennzeichnet, dass** nach der Sortieranlage eine vollautomatische Kistenabfüll- und Kistentransportvorrichtung vorhanden ist.

9. Vorrichtung gemäß einem der Ansprüche 1 bis 8, **dadurch gekennzeichnet, dass** vor der Aufgabeeinrichtung ein Vorzerkleinerer umfassend eine Unterlage sowie Zerkleinerungsmeißel und Gegenmeißel als Teil der Brechanlage vorhanden ist, wobei Unterlage, Zerkleinerungsmeißel und Gegenmeißel derart beweglich sind, dass ein auf der Unterlage liegender zu zerkleinernder Polysiliciumstab oder ein Polysiliciumbruchstück zwischen den Meißeln derart justiert werden kann, dass alle Meißel im Bereich des Polysiliciumstabs oder des Polysiliciumbruchstücks Kontakt zum Polysiliciumstab (Polysiliciumbruchstück) besitzen und die Zerkleinerungsmeißel vor oder hinter dem Polysiliciumstab (Polysiliciumbruchstück) in ihrer Wirkachse weiter bis auf einen Sicherheitsabstand zum Gegenmeißel gefahren werden können,
sowie eine Transportvorrichtung vorhanden ist, die den Si-Bruch vom Vorzerkleinerer zur Aufgabevorrichtung befördert.

10. Verfahren zum Zerkleinern und Sortieren von Polysilicium mittels einer Vorrichtung gemäß einem der Ansprüche 1 bis 9.

11. Verfahren gemäß Anspruch 10, **dadurch gekennzeichnet, dass** ein Polysilicium-Grobbruch in eine Brecheranlage, bei der eine variable Einstellung mindestens eines Brechparameters möglich ist, gefördert wird und dort zu einem Polysilicium-Bruch zerkleinert wird, der anschließend in eine Sortieranlage gefördert und dort klassiert wird, wobei in der Sortieranlage jeweils ein Ist-Wert für einen definierten Parameter des Polysilicium-Bruchs gemessen wird und der gemessene Ist-Wert an eine übergeordnete Steuer- und Regeleinrichtung weitergeleitet wird und in der Steuer- und Regeleinrichtung mit einem vorgegebenen Soll-Wert verglichen wird und bei einer Abweichung zwischen Ist-Wert und Soll-Wert die Steuer- und Regeleinrichtung die Einstellung des Brechparameters der Brecheranlage derart verändert, dass sich der nun gemessene Ist-Wert des Polysilicium-Bruchs dem vorgegebenen Soll-Wert angleicht.

12. Verfahren gemäß Anspruch 10 oder 11, **dadurch gekennzeichnet, dass** ein Polysilicium-Stab in einer Vorrichtung gemäß Anspruch 8 ohne thermische Vorbehandlung zu einem Polysilicium-Bruch zerkleinert wird.

## Claims

1. Device for comminuting and sorting polycrystalline silicon, comprising an instrument for feeding a coarse polysilicon fraction into a crushing system, the crushing system and a sorting system for classifying the polysilicon fraction, **characterized in that** the device is provided with a controller which allows variable adjustment of at least one crushing parameter in the crushing system and at least one sorting parameter in the sorting system.

2. Device according to Claim 1, **characterized in that** it comprises a conveyor device from the crushing system to the sorting system.

3. Device according to Claim 1 or 2, **characterized in that** the sorting system is provided with a measuring instrument for defined parameters of the classified polysilicon fraction, and this measuring instrument is connected to a superordinate control and regulating instrument which compares the measured parameters with a predetermined parameter and, if there is a deviation between the measured parameter and the predetermined parameter, can modify the setting of the crushing parameter of the crushing system and of the sorting parameter of the sorting system so that the parameter then measured approximates the predetermined parameter.

4. Device according to Claim 1, 2 or 3, **characterized in that** the crushing system is a multistage crushing system consisting of from 1 to 10 crushers, preferably from 1 to 3 crushers.

5. Device according to Claim 4, **characterized in that** the crushers are roll crushers or jaw crushers, preferably roll crushers, particularly preferably spiked roll crushers.

6. Device according to one of Claims 1 to 5, **characterized in that** the sorting system consists of a multistage mechanical screening system and a multistage optoelectronic separating system.

7. Device according to one of Claims 1 to 6, **characterized in that** a two-stage mechanical screening system is used in combination with a three-stage optoelectronic separating system constructed in a tree structure, in which the sorting of the polysilicon fraction is carried out by means of online monitoring according to one or more criteria selected from the group length, surface, shape, morphology, color and weight of the polysilicon fragments.

8. Device according to one of Claims 1 to 7, **characterized in that** a fully automatic container filling and container transport device is provided after the sorting system.

9. Device according to one of Claims 1 to 8, **characterized in that** a pre-comminuter comprising a support as well as comminuting chisels and counter chisels is provided before the feed instrument as part of the crushing system, the support, comminuting chisels and counter chisels being mobile so that a polysilicon rod lying on the support and to be comminuted or a polysilicon fragment can be fitted between the chisels, so that all chisels in the region of the polysilicon rod or the polysilicon fragment are in contact with the polysilicon rod (polysilicon fragment) and the comminuting chisels before or after the polysilicon rod (polysilicon fragment) can be moved further along their working axis to a safety distance from the counter chisels,
and a transport device is provided which conveys the Si fraction from the pre-comminuter to the feed device.

10. Method for comminuting and sorting polysilicon by means of a device according to one of Claims 1 to 9.

11. Method according to Claim 10, **characterized in that** a coarse polysilicon fraction is conveyed into a crushing system in which variable adjustment of at least one crushing parameter is possible, and is comminuted there to form a polysilicon fraction which is subsequently conveyed into a sorting system and classified there, an actual value for a defined parameter of the polysilicon fraction respectively being measured in the sorting system and the measured actual value being sent to a superordinate control and regulating instrument and compared with a predetermined setpoint value in the control and regulating instrument and, if there is a deviation between the actual value and the setpoint value, the control and regulating instrument modifies the setting of the crushing parameter of the crushing system so that the polysilicon fraction's actual value now measured approximates the predetermined setpoint value.

12. Method according to Claim 10 or 11, **characterized in that** a polysilicon rod is comminuted to form a polysilicon fraction in a device according to Claim 8 without thermal pre-treatment.

## Revendications

1. Dispositif de déchiquetage et de tri de silicium polycristallin, comprenant :
un dispositif d'introduction de fragments grossiers de polysilicium dans une installation de broyage,
l'installation de broyage et
une installation de tri qui classe les fragments de polysilicium,
**caractérisé en ce que**
le dispositif est doté d'une commande qui permet un réglage variable d'au moins un paramètre de broyage de l'installation de broyage et d'au moins un paramètre de tri de l'installation de tri.

2. Dispositif selon la revendication 1, **caractérisé en ce qu'**il comprend un dispositif de transport qui relie l'installation de broyage à l'installation de tri.

3. Dispositif selon la revendication 1 ou 2, **caractérisé en ce que** l'installation de tri est dotée d'un dispositif de mesure de paramètres définis des fragments de polysilicium classés et **en ce que** ce dispositif de mesure est relié à un système de commande et de régulation d'ordre plus élevé qui compare les paramètres mesurés à un paramètre prédéterminé et, en cas d'écart entre le paramètre mesuré et le paramètre prédéterminé, est en mesure de modifier le réglage du paramètre de broyage de l'installation de broyage et du paramètre de tri de l'installation de tri de telle sorte que le paramètre alors mesuré devienne égal au paramètre prédéterminé.

4. Dispositif selon la revendication 1, 2 ou 3, **caractérisé en ce que** l'installation de broyage est une installation de broyage à plusieurs étages constituée de 1 à 10 broyeurs et de préférence de 1 à 3 broyeurs.

5. Dispositif selon la revendication 4, **caractérisé en ce que** les broyeurs sont des broyeurs à cylindres ou des broyeurs à mâchoires, de préférence des broyeurs à cylindres et de façon particulièrement préférable des broyeurs à cylindres à ergots.

6. Dispositif selon l'une des revendications 1 à 5, **caractérisé en ce que** l'installation de tri est une installation de tamisage mécanique à plusieurs étages et constitue une installation de séparation optoélectronique à plusieurs étages.

7. Dispositif selon l'une des revendications 1 à 6, **caractérisé en ce qu'**il utilise une installation de tamisage mécanique à deux étages en combinaison avec une installation de séparation optoélectronique à trois étages configurée dans une structure arborescente, dans laquelle le tri des fragments de polysilicium s'effectue sous une surveillance en ligne selon un ou plusieurs critères sélectionnés dans l'ensemble constitué de la longueur, de la surface, de la forme, de la morphologie, de la couleur et du poids des morceaux de polysilicium.

8. Dispositif selon l'une des revendications 1 à 7, **caractérisé en ce qu'**un dispositif entièrement automatique de remplissage de caisses et de transport des caisses est prévu en aval de l'installation de tri.

9. Dispositif selon l'une des revendications 1 à 8, **caractérisé en ce qu'**il présente en amont du dispositif d'introduction un pré-déchiqueteur qui comprend une couche inférieure ainsi que des burins de déchiquetage et des contre-burins qui font partie de l'installation de broyage, la couche inférieure, les burins de déchiquetage et les contre-burins pouvant être déplacés de manière à pouvoir ajuster un barreau de polysilicium à déchiqueter placé sur la couche inférieure ou un morceau de polysilicium entre les burins de telle sorte que tous les burins soient en contact avec le barreau de polysilicium (le morceau de polysilicium) dans la zone occupée par le barreau de polysilicium ou le morceau de polysilicium, les burins de déchiquetage pouvant être éloignés dans leur axe d'action jusqu'à une distance de sécurité des contre-burins en amont ou en aval du barreau de polysilicium (morceau de polysilicium), et **en ce qu'**il comprend un dispositif de transport qui transporte les fragments de Si entre le pré-déchiqueteur et le dispositif d'alimentation.

10. Procédé de déchiquetage et de tri de polysilicium au moyen d'un dispositif selon l'une des revendications 1 à 9.

11. Procédé selon la revendication 10, **caractérisé en ce que** des fragments grossiers de polysilicium sont transportés dans une installation de broyage qui permet un réglage variable d'au moins un paramètre de broyage pour y être déchiquetés en fragments de polysilicium qui sont ensuite transportés dans une installation de tri pour y être classés, une valeur effective d'un paramètre défini des fragments de polysilicium étant respectivement mesurée dans l'installation de tri et la valeur effective mesurée étant transmise à un système de commande et de régulation d'ordre plus élevé pour être comparée dans le système de commande et de régulation à une valeur de consigne prédéterminée, et **en ce qu'**en cas d'écart entre la valeur effective et la valeur de consigne, le système de commande et de régulation modifie le réglage du paramètre de broyage de l'installation de broyage de telle sorte que la valeur effective mesurée ensuite sur les fragments de polysilicium devienne égale à la valeur de consigne prédéterminée.

12. Procédé selon la revendication 10 ou 11, **caractérisé en ce qu'**un barreau de polysilicium est déchiqueté en fragments de polysilicium dans un dispositif selon la revendication 8, et ce sans pré-traitement thermique.
